# EUROPEAN PATENT APPLICATION

(11) **EP 4 664 509 A1**
(43) Date of publication of application: **17.12.2025**
(21) Application number: 24770777.1
(22) Date of filing: 08.03.2024
(51) Int. Cl.: H01L 21/683, C09J 5/00, H01L 21/304

(54) **METHOD FOR PROCESSING PLATE-SHAPED BASE MATERIAL**

(30) Priority: 10.03.2023 JP 2023038006
(71) Applicant: Denka Company Limited, Tokyo 103-8338 (JP)
(72) Inventor: YAMAMOTO, Shota, Tokyo 103-8338 (JP); TANIGAWA HOSHINO, Takako, Tokyo 103-8338 (JP); TAKAHASHI, Yusuke, Tokyo 103-8338 (JP); KURIMURA, Hiroyuki, Tokyo 103-8338 (JP)
(74) Representative: Gulde & Partner
(86) International application number: PCT/JP2024/009061
(87) International publication number: WO 2024/190671

(57) **Abstract**

A method for processing a plate substrate, including a step A of bonding a plate substrate (1) and an optically transparent plate substrate (2) through a temporary fixing composition, a step B of curing the composition to form an adhesive layer and bond the substrates (1) and (2) to each other, a step C of processing the substrate (1) or (2), and a step D of irradiating the adhesive layer with laser light from the substrate (2) side to decompose the adhesive layer and generate outgas, and peeling the substrates (1) and (2) from each other by the outgas, wherein in the step D: a part of the substrate (2) is linearly masked to form a linear region where the adhesive layer is not irradiated with the laser light, the linear region has a shape surrounding a part or an entirety of the adhesive layer, an area of the adhesive layer surrounded by the linear region is 90.2% or more of a total area of the adhesive layer; and a ratio of a mask length to an outgas retention length is 0.15% or more, each measured along a line connecting a peeling start point and a peeling end point.

## Description

### TECHNICAL FIELD

The present invention relates to a method for processing a plate substrate.

Priority is claimed on Japanese Patent Application No. 2023-38006, filed March 10, 2023, the content of which is incorporated herein by reference.

### BACKGROUND ART

In the manufacture of an electronic device, a wafer-type substrate having a thickness of approximately several hundred µm is often used, which is obtained by using an inorganic material typified by silicon as a substrate and performing processing such as forming an insulating film, forming a circuit, and thinning by grinding on a surface of the substrate. However, since many substrates are made of brittle and easily breakable materials, it is necessary to take measures to prevent damage, particularly when thinning by grinding. As such necessary measures, a method is adopted in the related art, which attaches a temporary fixing protective tape to a surface (also referred to as a rear surface) opposite to the surface to be ground, which can be peeled off after a processing step,. This tape uses an organic resin film as a substrate. Although the tape has flexibility, the strength and heat resistance are insufficient, and it is not suitable for use in high-temperature processes.

Therefore, a system is proposed in which the substrate for an electronic device is bonded to a support member such as silicon or glass through an adhesive to impart sufficient durability with respect to conditions for a grinding step or an electrode forming step. In this case, an adhesive layer is important when bonding the substrate to the support member. For such an adhesive layer, it is required that the substrate can be bonded to the support member without a gap, that it has a sufficient durability to withstand subsequent steps, and finally that the thinned wafer can be easily peeled off from the support member, that is, can be temporarily fixed.

In such a wafer processing, a spin coating step, a vacuum bonding and photocuring step, a thinning processing step by grinding and polishing, a high temperature treatment step, a laser peeling step, and a temporary fixing agent removing step are mainly performed.

In the spin coating step, in order to uniformly form a film of the temporary fixing agent on the wafer, it is required that the temporary fixing agent has an appropriate viscosity and is a Newtonian fluid (or has a shear viscosity independent of shear rate).

In the vacuum bonding and photocuring step, the temporary fixing agent is required to be cured by irradiation with light such as ultraviolet rays (UV) in a short time on a support member such as glass, and to generate less outgas (low outgas generation).

In the thinning processing step by grinding and polishing, in order to avoid damage caused by the load of a grinding machine being applied locally to the substrate, the temporary fixing agent is required to have an appropriate hardness to distribute the load in the in-plane direction while preventing localized sinking of the substrate and maintaining the flatness. Furthermore, the adhesive strength with the support member, an appropriately high elastic modulus to protect the edge, and chemical resistance are also required.

In the high temperature treatment step, the temporary fixing agent is required to have the heat resistance that can withstand a high temperature treatment (for example, at 300°C or higher for one hour or longer) in a vacuum for a long time.

In the laser peeling step, the temporary fixing agent is required to be capable of peeling off at high speed with a laser such as a UV laser.

In the removing step, in addition to easy peeling property that allows the substrate to be easily peeled off from the support member, aggregation characteristics that prevent adhesive residues from remaining on the substrate after peeling and easy cleanability are required.

In these circumstances, Patent Document 1 discloses a method for manufacturing a semiconductor chip, including providing a photothermal conversion layer between a semiconductor chip and a light-transmitting support member. This photothermal conversion layer is decomposed by irradiation with radiative energy such as laser light, and it is possible to separate the semiconductor chip from the support member without damaging the semiconductor chip. This patent document discloses that chipping during dicing can be effectively prevented.

### Citation List

### Patent Document

Patent Document 1: Japanese Unexamined Patent Application, First Publication No. 2005-159155

### SUMMARY OF INVENTION

### Technical Problem

In peeling off the temporary fixing agent cured on the wafer, a laser is sweep-irradiated through a transparent support such as glass, and the temporary fixing agent at the irradiated location is decomposed to form a hole (a recessed portion in a state of being covered with the support). The gas that is vaporized in the hole expands at a high temperature, and thus the support is pushed up and is easily peeled off.

However, during the time period between the irradiation of the laser and the operation of peeling off a glass support and the wafer, the glass support may come into contact with the wafer due to its own weight, and the glass support and the wafer may be re-bonded due to the adhesion of the low molecular component resulting from decomposition of the temporary fixing agent. When the re-bonding occurs, the peeling property deteriorates, and thus the workability deteriorates.

In addition, the problem of re-bonding is a problem that is generally present not only in the processing of a wafer but also in a method for processing a plate substrate (for example, glass) using a temporary fixing agent. That is, in a case where the two substrates are bonded to each other by curing the temporary fixing agent, even when the temporary fixing agent is decomposed by irradiation with a laser, the two substrates may be re-bonded to each other due to the adhesion of the low molecular component resulting from decomposition of the temporary fixing agent, when the time until the two substrates are peeled off from each other is long.

The present invention has been completed in view of the above-described problems, and an object thereof is to provide, in one embodiment, a method for processing a substrate using a temporary fixing composition, in which the substrate can be peeled off even when a long time has passed after the laser light irradiation to an adhesive layer obtained by curing the temporary fixing composition.

### Solution to problem

As a result of intensive studies, the present inventors have found that, when an adhesive layer obtained by curing a temporary fixing composition is irradiated with laser light, a region where a part of the adhesive layer is not irradiated with the laser light is formed by masking, and as a result of an outgas surrounding effect by the region, contact between the substrates is prevented, and a problem of re-bonding can be alleviated. The present invention has been completed based on the above findings, and is illustrated below.

[1] A method for processing a plate substrate, the method including a step A of bonding a plate substrate (1) and an optically transparent plate substrate (2) through a temporary fixing composition, a step B of curing the temporary fixing composition to form an adhesive layer and bond the substrate (1) and the substrate (2) to each other, a step C of processing the substrate (1) or the substrate (2), and a step D of irradiating the adhesive layer with laser light from the substrate (2) side to decompose the adhesive layer and generate outgas, and peeling the substrate (1) and the substrate (2) from each other by the outgas, in which in the step D, a part of the substrate (2) is linearly masked to form a linear region where the adhesive layer is not to be irradiated with the laser light, wherein the linear region has a shape surrounding a part or an entirety of the adhesive layer, and an area of the adhesive layer surrounded by the linear region is 90.2% or more of a total area of the adhesive layer, and in the step D, a ratio of a mask length to an outgas retention length is 0.15% or more, each of the lengths measured along a line connecting a peeling start point and a peeling end point.
[2] The method according to [1], in which a line width of masking is 0.2 mm or more and 1.2 mm or less in 95% or more of an entire circumference of the linear region.
[3] The method according to [1] or [2], in which, in the step D, a peel resistance measured 2 hours after the irradiation with the laser light is 40 N or less.
[4] The method according to any one of [1] to [3], in which the substrate (1) is a substrate of a thin wafer.
[5] The method according to any one of [1] to [4], in which the substrate (2) is glass.
[6] The method according to any one of [1] to [5], in which the temporary fixing composition contains the following component:
   a polymerizable component (A).
[7] The method according to [5], in which the temporary fixing composition contains the following components:
   a polymerization initiator (B), and
   an ultraviolet absorber (C).
[8] The method according to [7], in which the temporary fixing composition contains 0.01 to 10 parts by mass of the component (B) and contains 0.01 to 15 parts by mass of the component (C) with respect to a total of 100 parts by mass of the component (A).
[9] The method according to any one of [1] to [8], in which the area (a) is 95.50% to 97.00%.
[10] The method according to any one of [1] to [9], in which the ratio (b) is 0.30% to 0.50%.

### Advantageous Effects of Invention

According to one embodiment of the present invention, it is possible to provide a method for processing a substrate using a temporary fixing composition, in which the substrate can be peeled off even when a long time has passed after laser light -rradiation to an adhesive layer obtained by curing the temporary fixing composition.

### BRIEF DESCRIPTION OF DRAWINGS

[FIG. 1] A diagram showing a masking method in an embodiment of the present invention.
[FIG. 2A] A diagram showing meanings of an outgas retention length and a mask length in the embodiment of the present invention.
[FIG. 2B] A diagram showing the meanings of the outgas retention length and the mask length in the embodiment of the present invention.
[FIG. 3] A diagram for describing the definition of a line width of the masking in the embodiment of the present invention.
[FIG. 4] A diagram showing a masking method in another embodiment of the present invention.
[FIG. 5] A diagram showing the masking method in another embodiment of the present invention.
[FIG. 6A] A diagram for describing a method of measuring a peel resistance in another embodiment of the present invention.
[FIG. 6B] A diagram for describing a method of measuring a peel resistance in another embodiment of the present invention.

### DESCRIPTION OF EMBODIMENTS

Next, embodiments of the present invention are described in detail. The present invention is not limited to the following embodiments, and it should be understood that appropriate design changes, improvements, and the like can be made based on the normal knowledge of those skilled in the art without departing from the spirit of the present invention.

In the present specification, unless otherwise specified, a numerical range includes an upper limit value and a lower limit value. In the present specification, (meth)acrylate refers to a compound having one or more (meth)acryloyl groups in one molecule. The monofunctional (meth)acrylate refers to a compound having one (meth)acryloyl group in one molecule. The polyfunctional (meth)acrylate refers to a compound having two or more (meth)acryloyl groups in one molecule. The n-functional (meth)acrylate refers to a compound having n (meth)acryloyl groups in one molecule. The polyfunctional (meth)acrylate may have only an acryloyl group, may have only a methacryloyl group, or may have both an acryloyl group and a methacryloyl group as the polymerizable functional group.

### (1. Step A)

In one embodiment of the present invention, a plate substrate (1) and an optically transparent plate substrate (2) are bonded to each other through a temporary fixing composition (step A). The reason why the substrate (2) is optically transparent is that the temporary fixing composition is irradiated with laser light to be cured to form an adhesive layer, and the adhesive layer is irradiated with laser light to be decomposed. In the present invention, the substrate to be processed may be any of the substrate (1) or the substrate (2), or both the substrate (1) and the substrate (2).

The materials of the substrate (1) and the substrate (2) are not limited, and can be an inorganic substrate such as a silicon wafer, glass, crystal, sapphire, diamond, indium phosphide, silicon carbide, gallium arsenide, quartz, calcium fluoride, or magnesium fluoride, or an organic substrate such as plastic. An explanation is given below with respectr to an example in which the substrate (1) is a substrate of a thin wafer and the substrate (2) is a support member, but the present invention should be applibable to other combinations as well. In addition, although the explanation is made below with the substrate (2) as the support member, the substrate (2) itself can also be a processing target.

The specific composition of the temporary fixing composition is not limited as long as the temporary fixing composition satisfies the conditions of being curable and decomposable by laser light and generating an outgas during decomposition, and it may be any composition as long as it is capable of bonding. For example, the temporary fixing composition may be one containing a (meth)acrylic compound, a urethane compound, an epoxy compound, a silicone compound or other thermoplastic resins, or may be an adhesive tape. In one embodiment of the present invention, the step of bonding the substrate (1) and the substrate (2) is preferably performed through a temporary fixing composition containing the following component (A), and more preferably through a temporary fixing composition containing the following components (A) to (C).
(A) A polymerizable component
(B) A polymerization initiator
(C) An ultraviolet absorber

### (1-1. Component (A))

The polymerizable component which is the component (A) contained in the temporary fixing composition according to the present embodiment is preferably a polymerizable organic compound component, and more preferably contains a (meth)acrylate. The polymerizable component containing a (meth)acrylate plays a role in forming a (meth)acrylic polymer skeleton. In addition, the temporary fixing composition according to the present embodiment may contain a non-polymerizable component, and the amount of the non-polymerizable component is preferably less than 15 parts by mass with respect to 100 parts by mass of the total amount of the non-polymerizable component and the component (A). In the present specification, the "non-polymerizable component" is defined as a component other than the component (B), that is, a component which is not used as a polymerization initiator in the related art.

The polymerizable component which is the component (A) contained in the temporary fixing composition according to the present embodiment preferably contains a (meth)acryloyl group, and in this case, the polymerizable component plays a role in forming a (meth)acrylic polymer skeleton. The component (A) preferably may include a compound having two or more (meth)acryloyl groups. The component (A) may be a monofunctional (meth)acrylate, or a polyfunctional (meth)acrylate such as a difunctional (meth)acrylate or at-least-tri-functional (meth)acrylate, or a mixture thereof. In addition, the component (A) may preferably include a combination of a polyfunctional (meth)acrylate and a monofunctional (meth)acrylate (more preferably a combination of a difunctional (meth)acrylate and a monofunctional (meth)acrylate), a combination of a polyfunctional (meth)acrylate and a polymerizable polymer (more preferably a combination of a difunctional (meth)acrylate and a polymerizable polymer), or a combination of a polyfunctional (meth)acrylate, a monofunctional (meth)acrylate, and a polymerizable polymer (more preferably a combination of a difunctional (meth)acrylate, a monofunctional (meth)acrylate, and a polymerizable polymer). The component (A) has none of a benzophenone skeleton, a triazole skeleton, a hydroxyphenyltriazine skeleton, and a phenol skeleton (that is, the component (C) described later is not included). It is preferable that the component (A) does not have a nitrogen atom in the molecule.

From the viewpoint of providing a rigid structure, examples of the polyfunctional (meth)acrylate that can be contained in the component (A) include an aromatic difunctional (meth)acrylate, an alicyclic difunctional (meth)acrylate, and a mixture thereof. The component (A) may include an acyclic polyfunctional (meth)acrylate. The polyfunctional (meth)acrylate may be a monomer, a polymer, or a mixture thereof. That is, the above-described polymerizable polymer may be a polymer of a polyfunctional (meth)acrylate monomer. The molecular weight of the polyfunctional (meth)acrylate monomer is preferably 900 or less, more preferably 700 or less, still more preferably 500 or less, and even still more preferably 400 or less. The molecular weight of the polyfunctional (meth)acrylate monomer is preferably 100 or more and more preferably 200 or more.

Examples of the aromatic difunctional (meth)acrylate include 9,9-bis[4-(2-hydroxyC₁ to C₂₀ alkoxy)phenyl]fluorene di(meth)acrylate, C₁ to C₂₀ alkoxylated bisphenol A di(meth)acrylate, benzyl di(meth)acrylate, 1,3-bis(2-(meth)acryloyloxyC₁ to C₂₀ alkyl)benzene, 2,2-bis(4-(meth)acryloxydioxyphenyl)propane, and structural isomers thereof.

Preferably, a di(meth)acrylate having one or more skeletons selected from a fused ring skeleton, for example, fluorene, indene, indecene, anthracene, azulene, or triphenylene may be included.

Examples of the alicyclic difunctional (meth)acrylate include C₁ to C₂₀ alkoxylated hydrogenated bisphenol A di(meth)acrylate, 1,3-di(meth)acryloyloxydadamantane, tricyclo C₁₀ to C₂₀ alkanedimethanol di(meth)acrylate, dicyclo C₅ to C₂₀ di(meth)acrylate, or structural isomers thereof.

Examples of the acyclic difunctional or polyfunctional (meth)acrylate include 1,3-butanediol di(meth)acrylate, 1,4-butanediol di(meth)acrylate, 1,6-hexanediol di(meth)acrylate, 1,9-nonanediol di(meth)acrylate, 1,10-decanediol di(meth)acrylate, neopentyl glycol di(meth)acrylate, neopentyl glycol-modified trimethylolpropane di(meth)acrylate, stearic acid-modified pentaerythritol di(meth)acrylate, tripropylene glycol di(meth)acrylate, and caprolactone-modified hydroxypivalic acid neopentyl glycol di(meth)acrylate.

In addition, the component (A) may include a polyfunctional (meth)acrylate of three or more functions. Examples of the trifunctional (meth)acrylate include isocyanuric acid ethylene oxide-modified tri(meth)acrylate, pentaerythritol tri(meth)acrylate, trimethylolpropane tri(meth)acrylate, and tris[(meth)acryloyloxyethyl] isocyanurate.

Examples of the (meth)acrylate having four or more functions include ditrimethylolpropane tetra(meth)acrylate, dimethylolpropane tetra(meth)acrylate, pentaerythritol tetra(meth)acrylate, pentaerythritol ethoxytetra(meth)acrylate, dipentaerythritol penta(meth)acrylate, and dipentaerythritol hexa(meth)acrylate.

In addition, the monofunctional (meth)acrylate which may be contained in the component (A) is preferably a monofunctional (meth)acrylate having a molecular weight of 550 or less, and more preferably a monofunctional alkyl (meth)acrylate having an alkyl group.

As the alkyl group, one or more selected from a linear alkyl group, a branched alkyl group, and an alicyclic alkyl group are preferable, and one or more selected from a linear alkyl group and a branched alkyl group are more preferable. From the viewpoint of improving compatibility with other components, the component (A) preferably has a long chain branched or cyclic alkyl group. For example, the component (A) preferably has a branched alkyl group such as an isostearyl group, an isotetracosanil group (for example, a 2-decyl-1-tetradecanyl group), or an isotriacontanyl group (for example, a 2-tetradecyl-1-octadecanyl group) having, for example, 18 to 40 carbon atoms, and more preferably having 18 to 32 carbon atoms, or a cycloalkyl group. By using such a component having a long chain, a high molecular weight, and a pronounced aliphatic hydrocarbon nature (more preferably, by increasing the aliphatic hydrocarbon nature of the entire system), it is possible to improve the low volatility, chemical resistance, and heat resistance required for the temporary fixing composition.

As the monofunctional (meth)acrylate which may be contained in the component (A), one or more selected from the group consisting of stearyl (meth)acrylate, isostearyl (meth)acrylate, behenyl (meth)acrylate, 2-decyl-1-tetradecanyl (meth)acrylate, 2-dodecyl-1-hexadecanyl (meth)acrylate, and 2-tetradecyl-1-octadecanyl (meth)acrylate are preferable. The monofunctional (meth)acrylate which may be contained in the component (A) is preferably a (meth)acrylate of the following Formula 1. 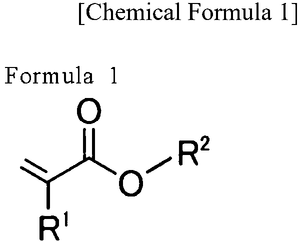 In the formula, R¹ is a hydrogen atom or a methyl group, and a hydrogen atom is more preferable. R² is an alkyl group, and the number of carbon atoms thereof is preferably 18 to 32.

As the monofunctional alkyl (meth)acrylate in which R² is an alkyl group having 18 to 32 carbon atoms, (meth)acrylates having a linear or branched alkyl group, such as stearyl (meth)acrylate, isostearyl (meth)acrylate, nonadecyl (meth)acrylate, eicodecyl (meth)acrylate, behenyl (meth)acrylate, 2-decyl-1-tetradecanyl (meth)acrylate, and 2-tetradecyl-1-octadecanyl (meth)acrylate are preferable.

One or more of these (meth)acrylates can be used.

In a preferred embodiment, the amount of the non-polymerizable component contained in the temporary fixing composition according to the present embodiment may be 0% by mass or more and less than 10% by mass, or 0% by mass or more and less than 5% by mass. More preferably, the temporary fixing composition according to the present embodiment may not contain the non-polymerizable component except for the component (B).

### (1-2. Component (B))

The polymerization initiator which is the component (B) contained in the temporary fixing composition according to the present embodiment is a substance capable of initiating the polymerization of the component (A). As the polymerization initiator, a photopolymerization initiator is preferable. The photopolymerization initiator is a substance capable of initiating the polymerization of the component (A) by being irradiated with light. The preferred component (B) may be a photoradical polymerization initiator. The photoradical polymerization initiator refers to, for example, a compound in which a molecule is broken by irradiation with ultraviolet rays or visible rays (for example, a wavelength of 350 to 700 nm, preferably 365 to 500 nm, and more preferably 385 to 450 nm) to be split into two or more radicals. Examples of the photoradical polymerization initiator include bis(2,4,6-trimethylbenzoyl)phenylphosphine oxide, 2,4,6-trimethylbenzoyldiphenylphosphine oxide, bis(η5-2,4-cyclopentadiene-1-yl)-bis(2,6-difluoro-3-(1H-pyrrol-1-yl)-phenyl)titanium, 2-benzyl-2-dimethylamino-1-(4-morpholinophenyl)-butan-1-one, 2-dimethylamino-2-(4-methylbenzyl)-1-(4-morpholin-4-ylphenyl)-butan-1-one, 1-[4-(phenylthio)phenyl]-1,2-octanedione 2-O-benzoyloxime, and 1-[9-ethyl-6-(2-methylbenzoyl)-9H-carbazol-3-yl]ethanone 1-(O-acetyloxime). The component (B) may include one or more of these components or a combination of two or more thereof.

In the preferred embodiment of the present invention, the component (B) contained in the temporary fixing composition may include an acylphosphine oxide-based compound. Preferred examples of the acylphosphine oxide-based compound include bis(2,4,6-trimethylbenzoyl)phenylphosphine oxide and 2,4,6-trimethylbenzoyldiphenylphosphine oxide. It is preferable that the polymerization initiator has a relatively long absorption wavelength range for generating the radical that extends to a relatively long wavelength range, in addition to having high sensitivity and excellent deep curing properties due to the light fading properties. In the above-described preferred compounds, the absorption wavelength range is a range of a wavelength of approximately 440 nm, and the difference from the absorption wavelength range of the UV absorber used in the UV laser peeling described later is large. That is, the degree of inhibition of UV curing by the UV absorber is small, and radical polymerization can be initiated with light having a longer wavelength. Therefore, an effect that radical polymerization can be efficiently initiated and cured at a relatively high speed even in the coexistence of the UV absorber is obtained.

In a preferred embodiment, the polymerization initiator can be selected in terms of the absorbance. Specifically, the polymerization initiator can be selected from one or more compounds satisfying any one or more of the following conditions: absorbance at a wavelength of 365 nm is 0.5 or more, absorbance at a wavelength of 385 nm is 0.5 or more, and absorbance at a wavelength of 405 nm is 0.5 or more, when the compound is dissolved in a solvent (for example, acetonitrile or toluene) having no maximum absorption in a wavelength range of 300 to 500 nm at a concentration of 0.1% by mass. Examples of the compound satisfying such conditions include 1-[9-ethyl-6-(2-methylbenzoyl)-9H-carbazol-3-yl]ethanone 1-(O-acetyloxime) whose absorbance at a wavelength of 365 nm is 0.5 or more, 1-[4-(phenylthio)phenyl]-1,2-octanedione 2-O-benzoyloxime whose absorbance at wavelengths of 365 nm and 385 nm is 0.5 or more, bis(2,4,6-trimethylbenzoyl)phenylphosphine oxide, and 2,4,6-trimethylbenzoyldiphenylphosphine oxide whose absorbance at wavelengths of 365 nm, 385 nm, and 405 nm is 0.5 or more, when the compound is dissolved in acetonitrile as a solvent at a concentration of 0.1% by mass.

In addition, from the viewpoint of achieving both curability by the polymerization initiator and UV laser peeling property, bis(η5-2,4-cyclopentadiene-1-yl)-bis(2,6-difluoro-3-(1H-pyrrol-1-yl)-phenyl)titanium having an absorption wavelength range in a range of 400 to 500 nm can also be used as the polymerization initiator.

As the polymerization initiator (B), one or more compounds selected from an acylphosphine oxide-based compound, a titanocene-based compound, and an α-aminoalkylphenone-based compound are preferable in terms of reaction rate, heat resistance after curing, low outgas properties, and absorption characteristics in a region different from the wavelength of the UV laser used in the UV laser peeling described later and the absorption wavelength range of the UV absorber used in the UV laser peeling. In addition to those listed above, it is also possible to select oxime ester-based compound as a polymerization initiator for a resin composition for temporary fixing purposes for preventing damage from the bonding of the substrate to be processed to a support member until the heating step, which is not a layer for dealing with UV laser peeling, in the temporary fixing composition having a structure described later.

Examples of the acylphosphine oxide-based compound include bis(2,4,6-trimethylbenzoyl)phenylphosphine oxide and 2,4,6-trimethylbenzoyldiphenylphosphine oxide. Among these, bis(2,4,6-trimethylbenzoyl)phenylphosphine oxide is particularly preferable.

Examples of the titanocene-based compound include bis(η5-2,4-cyclopentadiene-1-yl)-bis(2,6-difluoro-3-(1H-pyrrol-1-yl)-phenyl)titanium.

Examples of the α-aminoalkylphenone-based compound include 2-benzyl-2-dimethylamino-1-(4-morpholinophenyl)-butan-1-one and 2-dimethylamino-2-(4-methylbenzyl)-1-(4-morpholin-4-ylphenyl)-butan-1-one.

Examples of the oxime ester-based compound include 1-[4-(phenylthio)phenyl]-1,2-octanedione 2-O-benzoyloxime and 1-[9-ethyl-6-(2-methylbenzoyl)-9H-carbazol-3-yl]ethanone 1-(O-acetyloxime). Among these, 1-[9-ethyl-6-(2-methylbenzoyl)-9H-carbazol-3-yl]ethanone 1-(O-acetyloxime) is preferable.

In the preferred embodiment of the present invention, the component (B) in the temporary fixing composition is one or more selected from bis(2,4,6-trimethylbenzoyl)phenylphosphine oxide, 2,4,6-trimethylbenzoyldiphenylphosphine oxide, and 1-[9-ethyl-6-(2-methylbenzoyl)-9H-carbazol-3-yl]ethanone 1-(O-acetyloxime).

The amount of the polymerization initiator (B) used is preferably 0.01 to 10 parts by mass, more preferably 0.01 to 5 parts by mass, and most preferably 0.01 to 3 parts by mass with respect to 100 parts by mass of the total amount of the component (A), in terms of reaction rate, heat resistance after curing, and low outgas properties. Typically, the amount used can be set to 0.1 to 2 parts by mass, and can be set to 0.1 to 1 part by mass. When the amount of the component (B) used is 0.01 parts by mass or more, sufficient curability is obtained, and when the amount thereof used is 10 parts by mass or less, an effect of hardly impairing low outgas properties and heat resistance is obtained.

### (1-3. Component (C))

The ultraviolet absorber (UV absorber) which is the component (C) contained in the temporary fixing composition according to the present embodiment refers to a compound whose molecule is broken, decomposed, and vaporized by irradiation with ultraviolet rays or a laser of visible rays, wherein when such decomposition and vaporization occurs at an interface between the support member and the adhesive layer obtained by curing the temporary fixing composition, it is possible to cancel the adhesive force between the adhesive layer and the support member, which is maintained until immediately before the peeling step. The preferred component (C) is a compound having one or more selected from the group consisting of a benzophenone skeleton, a triazole skeleton, a hydroxyphenyltriazine skeleton, and a phenol skeleton (preferably a hindered phenol skeleton), and more preferably a compound having a hydroxyphenyltriazine skeleton. The compounds with these skeletons are used in consideration of a degree of overlap with the UV laser wavelength in the UV absorption wavelength range and UV absorption characteristics at the same wavelength, and to achieve low outgas properties and heat resistance. As the ultraviolet absorber having a hydroxyphenyltriazine skeleton, 2-(2-hydroxy-4-[1-octyloxycarbonylethoxy]phenyl)-4,6-bis(4-phenylphenyl)-1,3,5-triazine is preferable.

The ultraviolet absorber which is the component (C) contained in the temporary fixing composition according to the present embodiment is preferably an ultraviolet absorber having a polymerizable functional group. The polymerizable functional group contained in the component (C) is preferably a (meth)acryloyl group.

With regard to the component (C) which is an ultraviolet absorber having a polymerizable functional group, an example thereof, which is particularly preferable in terms of compatibility with the resin component, UV absorption performance, low outgas perofrmance, and heat resistance, is one or more from the group consisting of 2-[2-hydroxy-5-[2-((meth)acryloyloxy)ethyl]phenyl]-2H-benzotriazole, 2-[1-(2-hydroxy-3,5-di-tert-pentylphenyl)ethyl]-4,6-di-tert-pentylphenyl (meth)acrylate, 2-(2-(meth)acryloyloxy,5-methyl)phenyl-2H-benzotriazole, 1,1-bis-[2-(meth)acryloyloxy,3-(2H-benzotriazole-2-yl),5-tertiary-octyl]methane, and 2,2'-dihydroxy-4,4'-di(meth)acryloyloxybenzophenone

The amount of the component (C) is preferably 0.01 to 15 parts by mass, more preferably 0.1 to 12 parts by mass, still more preferably 0.5 to 10 parts by mass, and even still more preferably 0.5 to 7 parts by mass with respect to 100 parts by mass of the total amount of the component (A). When the amount is 0.01 parts by mass or more, a sufficient UV laser peeling rate can be obtained, and when the amount is 15 parts by mass or less, an effect of hardly impairing low outgas properties and heat resistance can be obtained.

### (1-4. Application of Temporary Fixing Composition)

A method of bonding the substrate (1) and the substrate (2) to each other is not particularly limited, but is typically performed by applying a temporary fixing adhesive to the substrate (2) and then bonding the substrate (1) to the surface to which the temporary fixing adhesive is applied.

As a method of applying the temporary fixing adhesive, a known application method such as spin coating, screen printing, or various coaters can be used. The viscosity of the temporary fixing composition according to the present embodiment is preferably 500 mPa·s or more and more preferably 1,000 mPa·s or more at 23°C (atmospheric pressure) in terms of applying property and workability. The viscosity of the temporary fixing composition according to the present embodiment is preferably 15,000 mPa·s or less, more preferably 10,000 mPa·s or less, and still more preferably 5,000 mPa·s or less at 23°C (atmospheric pressure) in terms of ease of application and work efficiency. When the viscosity is 500 mPa·s or more, the ease of application, particularly the ease of application by spin coating, is excellent. When the viscosity is 15,000 mPa·s or less, work efficiency is excellent. The viscosity can be measured with a known viscometer.

Spin coating is, for example, a method that applies a composition to a surface of the substrate (2) by dropping the liquid composition onto the substrate (2) and rotating the substrate (2) at a predetermined rotation speed. A high-quality coating film can be efficiently produced by spin coating.

### (2. Step B)

In the step B, the temporary fixing composition is cured to form an adhesive layer, and the substrate (1) and the substrate (2) are bonded to each other. When bonding the substrate (1) and the substrate (2) to each other, the irradiation conditions are not particularly limited, but it is preferable to irradiate the substrate (1) and the substrate (2) with visible rays or ultraviolet rays (wavelength or center wavelength: 365 to 405 nm) such that the energy amount is 1 to 20000 mJ/cm². When the energy amount is 1 mJ/cm² or more, sufficient adhesive force is obtained, and when the energy amount is 20000 mJ/cm² or less, productivity is excellent, decomposition products from the polymerization initiator are unlikely to be generated, and the generation of outgas is prevented. The energy amount is preferably 1000 to 10000 mJ/cm² from the viewpoint of productivity, adhesive force, low outgas properties, and easy peeling.

The substrate (2) as the support member is not particularly limited as long as the substrate is optically transparent. Examples of the transparent substrates include inorganic substrates such as glass, crystal, sapphire, diamond, indium phosphide, silicon carbide, gallium arsenide, quartz, calcium fluoride, and magnesium fluoride, and organic substrates such as plastic. Among these, an inorganic substrate is preferable from the viewpoint of general-purpose properties and obtaining a remarkable effect. Among the inorganic substrates, one or more selected from glass and quartz are preferable. In particular, glass is preferable.

### (3. Step C)

After bonding the substrate (1) and the substrate (2), the substrate (1) or the substrate (2) is processed. In the case of manufacturing a thin wafer, a step of processing the substrate (1) to form a thin wafer is performed. The specifics of the processing are not particularly limited, but typical examples of the processing include thinning processing by grinding and polishing; molding; and heat treatment.

### (4. Step D)

In the step D, the adhesive layer is irradiated with laser light from the substrate (2) side to decompose the adhesive layer to generate outgas, which causes the substrate (1) and the substrate (2) to be peeled off from each other. By bonding the substrate (1) and the substrate (2), the temporary fixing composition is cured to form an adhesive layer. After the processing of the substrate (1) or the substrate (2) is completed, the substrate can be peeled off by scanning irradiation of the entire surface with laser light from the substrate (2) side. Preferably, a step of irradiating the adhesive layer with light having a wavelength of 385 nm or less and more preferably 300 to 385 nm to decompose the adhesive layer is performed. For example, the adhesive layer can be decomposed by scanning irradiation of the entire surface of the adhesive layer with a UV laser having a wavelength of 300 to 385 nm to scan. When the adhesive layer is decomposed, the substrate (1) can be peeled off from the substrate (2).

In this context, when the laser light is emitted from the substrate (2) side, it is important to mask a part of the substrate (2) to form a linear region where the adhesive layer is not supposed to be irradiated with the laser light. The linear region has a shape surrounding a part or an entirety of the adhesive layer, and an area of the adhesive layer surrounded by the linear region is 90.2% or more of the total area of the adhesive layer.

As described above, in a case where the time between the completion of the irradiation with the laser light and the peeling operation is long, the substrates may be re-bonded to each other. The reason for this is considered to be that outgas generated by the decomposition of the adhesive layer escapes from between the substrates over time, and the substrates come into contact with each other. Since the outgas has a role as a cushion that prevents the substrates from coming into contact with each other, it is considered that the re-bonding can be prevented by preventing the release of the outgas.

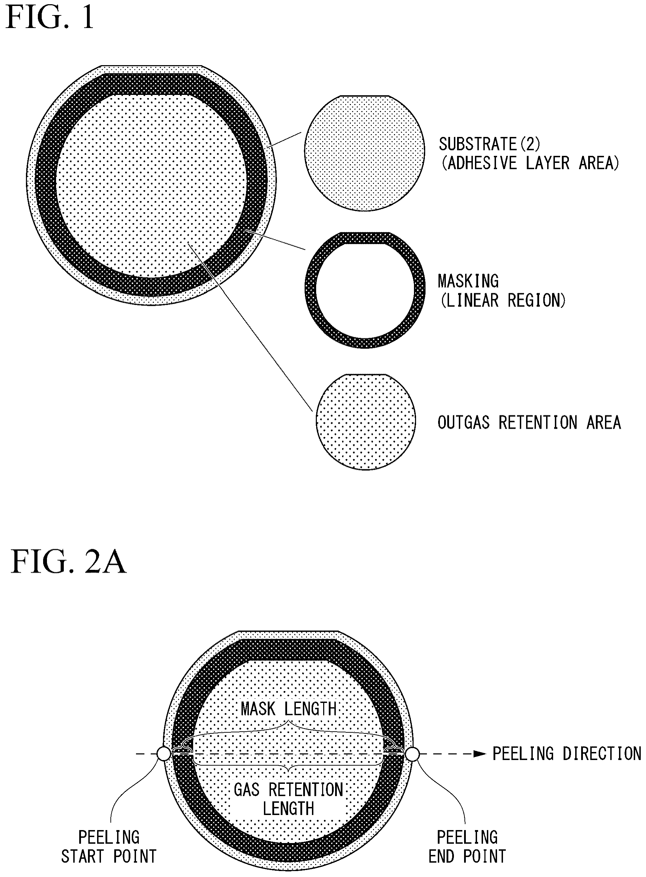

FIG. 1 shows a masking method in an embodiment of the present invention. The drawing is a top view as viewed from the substrate (2) side. In this embodiment, since the adhesive layer is formed on the entire surface of the substrate (2), the area of the substrate (2) is the same as the area of the adhesive layer.

As shown in FIG. 1, since a part of the surface of a substrate (2) is masked in a linear shape, a linear region where the adhesive layer is not irradiated with laser light is formed. Since the linear region is not irradiated with the laser light, the adhesive layer is not decomposed, and thus, the outgas generated by the decomposition of the adhesive layer inside the linear region is not easily released. As a result, even after a long time passes, the contact between the substrate (1) and the substrate (2) can be prevented, and the re-bonding can be prevented.

In order to ensure a retention effect of the outgas, the area of the adhesive layer surrounded by the linear region (hereinafter, also referred to as "outgas retention area") needs to be 90.2% or more of the total area of the adhesive layer. In addition, from the same perspective, the outgas retention area is preferably 91% or more, more preferably 92% or more, still more preferably 93% or more, even more preferably 94% or more, and even still more preferably 95% or more with respect to the total area of the adhesive layer. The upper limit of the outgas retention area is not particularly limited, but is typically 96% or less of the total area of the adhesive layer. In addition, in one preferred aspect of the present invention, the area is 95.50% to 97.00%. When the area is within this range, the peel resistance described later can be particularly reduced to a desired range.

In a case where the adhesive layer is not formed on the entire surface of the substrate (2) and is formed only on a portion inside the entire linear region, the outgas retention area is 100% of the total area of the adhesive layer.

In addition, a portion surrounded by the linear region in the adhesive layer is also referred to as a "surrounded portion" hereinafter.

The area of the adhesive layer surrounded by the linear region is an area surrounded by an inner contour line of the linear region, that is, the area of the linear region itself is not considered.

In order to ensure the retention effect of the outgas, in the step D, it is necessary that a ratio of the mask length to the outgas retention length is 0.15% or more, each of the lengths measured along a line connecting a peeling start point and a peeling end point. More specifically, the ratio is a value (%) obtained by Expression L2/L1 × 100 when an outgas retention length (that is, a length of a surrounded portion on the straight line S) on a straight line S connecting the peeling start point and the peeling end point is denoted by L1, and a mask length (that is, a length of the mask on the straight line S) is denoted by L2.

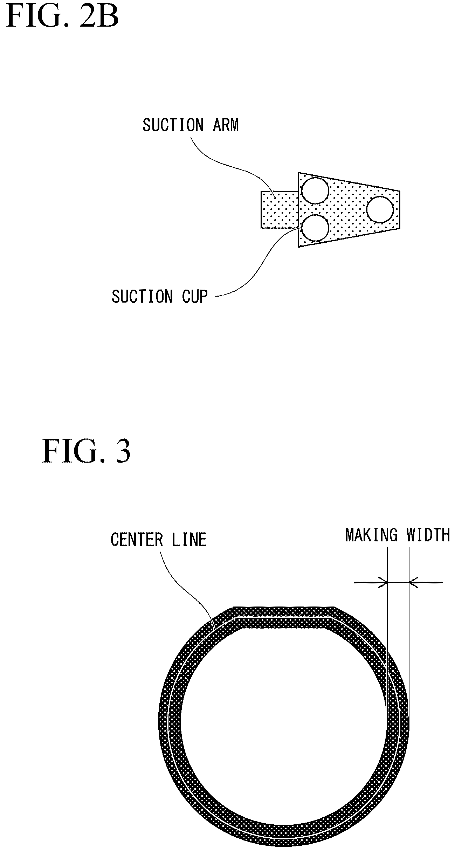

FIGs. 2A and 2B show a method of measuring the outgas retention length and the mask length in one embodiment of the present invention. The substrate (2) is peeled off by a method that attaches a suction arm to the substrate (2) with a suction cup attached thereto as shown in FIG. 2B and vertically pulls the suction arm upward, wherein a point at which the substrate (2) starts to be peeled off and a point at which the peeling is ended are defined as a peeling start point and a peeling end point, respectively, and a straight line S connecting both points is drawn. Of the length of the straight line S, a length passing through the surrounded portion having an outgas retention area is defined as an outgas retention length, and a length passing through the linear region is defined as a mask length. The mask length is the sum of the length at a portion close to the peeling start point and the length at a portion close to the peeling end point.

In addition, it is preferable that the peeling start point and the peeling end point are positioned on the straight line S passing through the vicinity of the center of the substrate (2). The straight line S is normally set such that a maximum diameter M of the substrate (2) is set at a position corresponding to the longest diagonal line.

By setting the ratio of the mask length to the outgas retention length to 0.15% or more, a sufficient retention effect of the outgas is ensured. From this perspective, the ratio of the mask length to the outgas retention length is preferably 0.20% or more, more preferably 0.25% or more, and still more preferably 0.30% or more. The upper limit of the ratio of the mask length to the outgas retention length is not particularly limited, but when the mask length is small, the outgas retention area is easily ensured, and thus the upper limit is preferably 1.00% or less, more preferably 0.90% or less, still more preferably 0.80% or less, and even still more preferably 0.70% or less.

In addition, in one preferred aspect of the present invention, the ratio is 0.30% to 0.50%. When the ratio is within this range, the peel resistance described later can be reduced to a particularly desired range.

In order to ensure the retention effect of the outgas, it is preferable that the line width of the masking is 0.2 mm or more in 95% or more of the entire circumference of the linear region. As shown in FIG. 3, the line width of the masking is a distance between an inner contour line and an outer contour line of the linear region measured at each point in a direction perpendicular to a center line of the linear region. When the line width of the masking measured in a portion of 95% or more of the length of the center line is 0.2 mm or more, outgas can be more reliably retained, and the effect of preventing re-bonding can be further enhanced.

From this perspective, the line width of the masking is more preferably 0.3 mm or more, more preferably 0.4 mm or more, and still more preferably 0.5 mm or more in 95% or more of the entire circumference of the linear region. Regarding the upper limit of the line width of the masking, since it is easy to ensure the outgas retention area when the line width of the masking is small, the line width is preferably 1.2 mm or less. For example, the line width can be set to 1.0 mm or less, 0.8 mm or less, or 0.6 mm or less.

In the step D, depending on the setting of the peeling start point and the peeling end point when peeling the substrate (2), the above-described mask length may be exactly twice the line width of the masking, but such a relationship is not necessarily required.

In a part of embodiments of the present invention, the linear region may have a shape in which the linear region is partially open. When the linear region is partially open, the non-decomposed adhesive layer has an open shape rather than a closed shape, so that the tip end of a peeling device is easily inserted when peeling the substrates from each other, and the substrates are physically easily peeled off. On the other hand, when the opening of the linear region is too large, there is a possibility that the retention effect of the outgas may be impaired, and thus it is preferable that the linear region is not opened. That is, it is preferable that the linear region forms a closed shape.

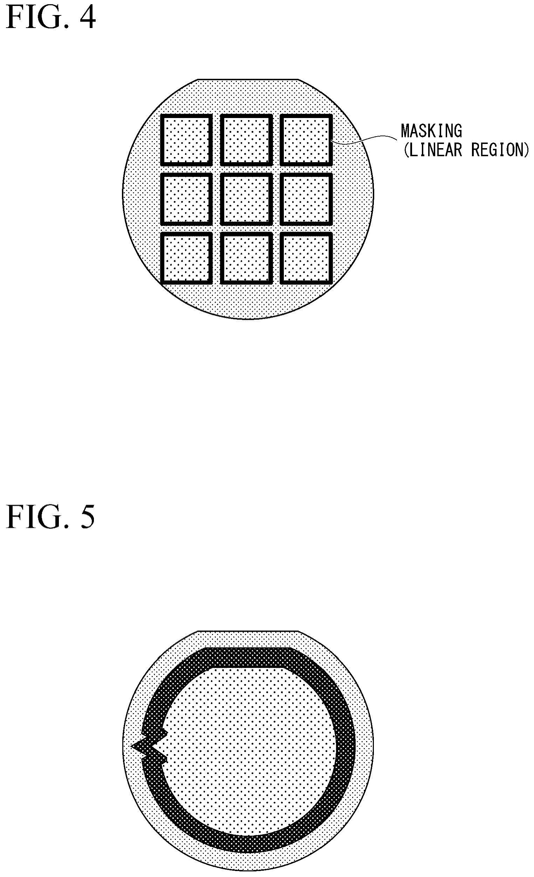

In addition, as shown in the embodiment of FIG. 4, the linear region does not necessarily need to be formed of a curve, and an acute angle, a right angle, or an obtuse angle may be present in a part of the linear region. More typically, for example, as shown in FIG. 5, the linear region may have a pointed portion (protrusion) as long as the outgas retention area satisfies the requirement of the present invention. The protrusion may function as a mark for alignment during masking or peeling.

In addition, the linear region may be provided such that only one surrounded portion is formed as shown in FIG. 1 or the like as long as the outgas retention area satisfies the requirement of the present invention, or may be provided such that a plurality of surrounded portions are formed as shown in FIG. 4.

With the above-described configuration of the present invention, outgas is retained, and even after a long time has passed after the irradiation with the laser light, the re-bonding of the substrates is prevented. It is preferable that the peel resistance is 40 N or less 2 hours after the irradiation with the laser light. In a still more preferred embodiment of the present invention, the peel resistance is 30 N or less, and more preferably 20 N or less.

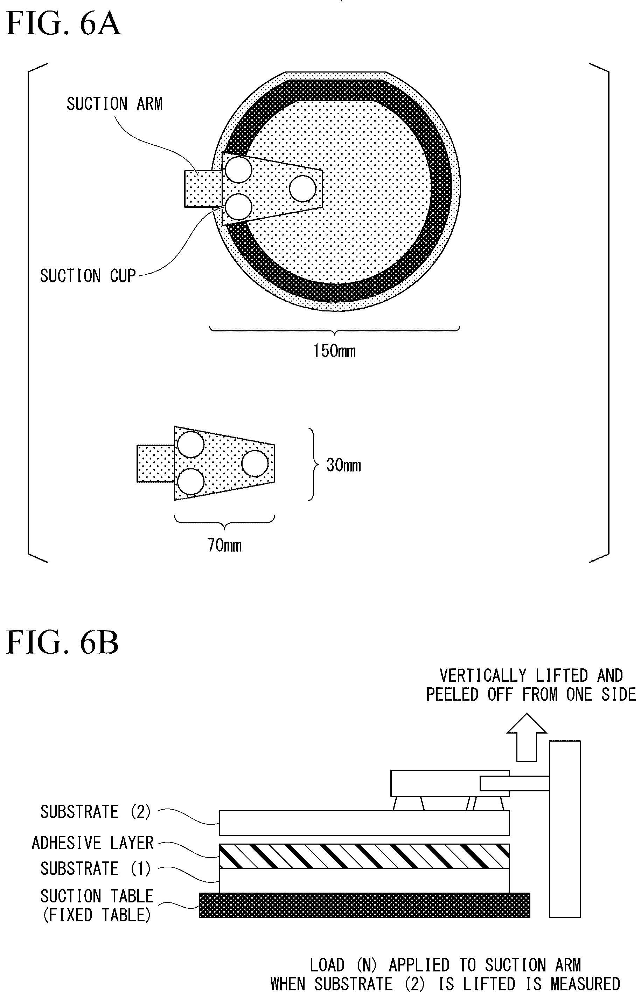

In the present specification, the peel resistance is measured as follows. As shown in FIG. 6B, a suction arm in which three suction cups having a diameter of 10 mm are attached from above to the substrate (2) of the test piece in a state where the substrate (1) is placed below and fixed on a suction table such as a suction table of a porous chuck type (refer to FIG. 6A) is attached. The substrate (2) is peeled off by a method in which the suction arm is vertically pulled up upward at 0.5 mm/s, and a load applied to the suction arm when the substrate (2) is lifted is measured and used as the measured value of the peel resistance.

### Examples

Hereinbelow, the present invention is described in more detail based on examples and comparative examples, but the present invention is not limited thereto.

Unless otherwise noted, the experiment was performed at 23°C and a humidity of 50%. A temporary fixing composition having the compositions (unit: part by mass) shown in Table 1 below was prepared and evaluated. The following compounds were selected as each of the components.

### (Temporary Fixing Composition)

The following was used as the component (A).
A-DOD-N: 1,10-decanediol diacrylate ("A-DOD-N" manufactured by Shin-Nakamura Chemical Co., Ltd., molecular weight: 282)

The following was used as the component (B).
Bis(2,4,6-trimethylbenzoyl)phenylphosphine oxide ("Omnirad 819" manufactured by IGM RESINS)

The following was used as the component (C).
Tinuvin 479: hydroxyphenyltriazine (HPT)-based ultraviolet absorber (2-(2-hydroxy-4-[1-octyloxycarbonylethoxy]phenyl)-4,6-bis(4-phenylphenyl)-1,3,5-triazine, "Tinuvin 479" manufactured by BASF SE)

**[Table 1]**

| Component | | Blend amount (parts by mass) |
|---|---|---|
| (A) | A-DOD-N | 100 |
| (B) | Omnirad 819 | 0.5 |
| (C) | Tinuvin 479 | 2 |

### (Preparation of Liquid Sample)

For each of the Comparative Examples and the Examples, as shown in Table 1, the materials were heated and mixed at 60°C to obtain a uniform liquid composition.

### (Preparation of Bonding Sample)

A 4-inch silicon wafer (disk shape having a thickness of 0.47 mm, and a diameter shown in Table 2 and Table 3) and a 4-inch glass support member (thickness: 0.7 mm) were bonded to each other using the prepared liquid composition. In the bonding, the thickness of the liquid composition was adjusted to 50 µm. After bonding, the bonding sample was cured with a black light having a wavelength of 365 nm under conditions of illuminance of 100 mW/cm², an irradiation time of 50 seconds, and an integrated light amount of 5000 mJ/cm², placed on a hot plate heated to 180°C, and subjected to a heat treatment for 30 minutes to prepare a test piece for laser peeling property evaluation. The liquid composition was applied to the entire bonding surface.

### (Evaluation of Laser Peeling Property)

A perfect circular area having a diameter of 110 mm fixed at the center of the obtained 4-inch test piece was irradiated with a UV laser having a wavelength of 355 nm to scan the entire surface of the test piece from the glass support member side of the test piece. As the UV laser, UV laser QLA-355 manufactured by Quark Technology, Inc. was used at an output of 8.5 W, a frequency of 40 kHz, a scan pitch of 200 µm, and a beam diameter of 200 µm.

In addition, when being irradiated with the UV laser, the masking with the shape shown in FIG. 1 was implemented for the Examples, and the masking was not implewmented for Comparative Example 1. For each of the Examples, the proportion of the outgas retention area, the ratio of the mask length to the outgas retention length, and the width of the masking were changed as shown in Tables 2 and 3. In Example 10, a protrusion shape as shown in FIG. 5 was provided.

After the irradiation with the UV laser was completed and 2 hours had passed (24 hours had passed only in Example 3), the peel resistance was measured for each of the Comparative Examples and the Examples by the following procedure. The results are shown in Tables 2 and 3.

As shown in FIG. 6, a suction arm in which three suction cups (made of fluorine rubber) having a diameter of 10 mm were attached from above to the substrate (2) of the test piece in a state where the substrate (1) was placed below and fixed on a suction table such as a suction table of a porous chuck type (the position at a distance of 1 mm from the end portion of the bonding sample was sucked) was attached. The substrate (2) was peeled off by a method in which the suction arm was vertically pulled up upward at 0.5 mm/s, and a load applied to the suction arm when the substrate (2) was lifted was measured and used as the measured value of the peel resistance.

The pass or fail of test for the peel resistance measured in each of the Comparative Examples and the Examples was determined according to the following criteria.
Good: Peel resistance ≤ 20 N
Fair: 20 N < peel resistance ≤ 40 N
Poor: 40 N < peel resistance

**[Table 2]**

| | Comparative Example 1 | Comparative Example 2 | Example 1 | Comparative Example 3 | Example 2 |
|---|---|---|---|---|---|
| Wafer size (diameter mm) | 150 | 150 | 150 | 150 | 150 |
| Proportion of outgas retention area (%) | - | 91.65 | 91.14 | 90.12 | 95.00 |
| Ratio of mask length to outgas retention length (%) | | 0.14 | 0.28 | 0.56 | 0.27 |
| Width of masking (mm) | 0 | 0.20 | 0.40 | 0.80 | 0.40 |
| Presence or absence of mask protrusion | - | No Protrusions | No Protrusions | No Protrusions | No Protrusions |
| Peel resistance (N) | >20 N (< 30 N) | >40 N | 20 N | >40 N | 15 N |
| Pass or fail | Fair | Poor | Good | Poor | Good |

**[Table 3]**

| | Example 3 | Example 4 | Example 5 | Example 6 | Example 7 | Example 8 | Example 9 | Example 10 |
|---|---|---|---|---|---|---|---|---|
| Wafer size (diameter mm) | 150 | 150 | 150 | 150 | 200 | 200 | 200 | 200 |
| Proportion of outgas retention area (%) | 95.00 | 97.35 | 95.78 | 96.82 | 95.45 | 95.06 | 94.67 | 95.45 |
| Ratio of mask length to outgas retention length (%) | 0.27 | 0.27 | 0.41 | 0.41 | 0.55 | 0.69 | 0.83 | 0.55 |
| Width of masking (mm) | 0.4 | 0.4 | 0.6 | 0.6 | 0.8 | 1.0 | 1.2 | 0.8 |
| Presence or absence of mask protrusion | No Protrusions | No Protrusions | No Protrusions | No Protrusions | No Protrusions | No Protrusions | No Protrusions | No Protrusions |
| Peel resistance (N) | 17 N | 17 N | 12 N | 11 N | 20 N | 20 N | 20 N | 20 N |
| Pass or fail | Good | Good | Good | Good | Good | Good | Good | Good |

As shown in Tables 2 and 3, in Examples 1 to 10 in which the proportion of the outgas retention area was 90.2% or more and the ratio of the mask length to the outgas retention length was 0.15% or more, the re-bonding was prevented due to the retention of the outgas even after 2 hours, and the evaluation of the peel resistance was excellent. In particular, even in Example 10 in which the protrusion was provided in the linear region of the masking, the peel resistance was low.

In addition, Example 3 is the same as Example 2 except that the peel resistance was measured after 24 hours had elapsed after the irradiation with the UV laser was completed, but it can be seen that the peel resistance was sufficiently low and maintained.

In Comparative Example 1, since the masking was not implemented, re-bonding occurred, and the peel resistance increased (exceeded 20 N and was less than 30 N). In Comparative Example 2, since the ratio of the mask length to the outgas retention length was less than 0.15%, the outgas could not be retained, the mask was destroyed, and the peel resistance increased. In Comparative Example 3, since the outgas retention area was less than 90.2%, the amount of outgas was insufficient to peel off the mask portion, and the peel resistance increased.

## Claims

1. A method for processing a plate substrate, the method comprising:
a step A of bonding a plate substrate (1) and an optically transparent plate substrate (2) through a temporary fixing composition;
a step B of curing the temporary fixing composition to form an adhesive layer and bond the substrate (1) and the substrate (2) to each other;
a step C of processing the substrate (1) or the substrate (2); and
a step D of irradiating the adhesive layer with laser light from the substrate (2) side to decompose the adhesive layer and generate outgas, and peeling the substrate (1) and the substrate (2) from each other by the outgas, wherein
in the step D, a part of the substrate (2) is linearly masked to form a linear region where the adhesive layer is not to be irradiated with the laser light, wherein the linear region has a shape surrounding a part or an entirety of the adhesive layer, and an area of the adhesive layer surrounded by the linear region is 90.2% or more of a total area of the adhesive layer, and
in the step D, a ratio of a mask length to an outgas retention length is 0.15% or more, each of the lengths measured along a line connecting a peeling start point and a peeling end point.

2. The method according to Claim 1, wherein
a line width of masking is 0.2 mm or more and 1.2 mm or less in 95% or more of an entire circumference of the linear region.

3. The method according to Claim 1 or 2, wherein
in the step D, a peel resistance measured 2 hours after the irradiation with the laser light is 40 N or less.

4. The method according to Claim 1 or 2, wherein
the substrate (1) is a substrate of a thin wafer.

5. The method according to Claim 1 or 2, wherein
the substrate (2) is glass.

6. The method according to Claim 1 or 2, wherein
the temporary fixing composition contains the following component: a polymerizable component (A).

7. The method according to Claim 6, wherein
the temporary fixing composition further contains the following components:a polymerization initiator (B), and an ultraviolet absorber (C).

8. The method according to Claim 7, wherein
the temporary fixing composition contains 0.01 to 10 parts by mass of the component (B) and contains 0.01 to 15 parts by mass of the component (C) with respect to a total of 100 parts by mass of the component (A).
